# EUROPÄISCHE PATENTSCHRIFT

(11) **EP 0 651 290 B1**
(45) Veröffentlichungstag und Bekanntmachung des Hinweises auf die Patenterteilung: **06.10.1999**
(21) Anmeldenummer: 94117064.9
(22) Anmeldetag: 28.10.1994
(51) Int. Cl.: G03F 3/10

(54) **Ein- und mehrfarbige Farbprüfbilder mit niedrigem optischen Punktzuwachs sowie Verfahren und Mittel für deren Herstellung**
Monochrome and polychrome color proofs with low optical dot growth and a process and means for their preparation
Feuilles d'épreuve en couleurs avec petit grossissement du point et procédé et dispositif pour leur production

(30) Priorität: 31.03.1994 DE 4411224; 02.11.1993 DE 4337379
(43) Veröffentlichungstag der Anmeldung: 03.05.1995
(73) Patentinhaber: DU PONT DE NEMOURS (DEUTSCHLAND) GMBH, 61352 Bad Homburg (DE); E.I. DU PONT DE NEMOURS AND COMPANY, Wilmington Delaware 19898 (US)
(72) Erfinder: Metzger, Bernhard, Dr., D-64291 Darmstadt (DE); Kraska, Ursula Annerose, Dr., D-64331 Weiterstadt (DE); Grossa, Mario, Dr., D-63303 Dreieich (DE)

(56) Entgegenhaltungen:
- EP-A- 0 186 184
- EP-A- 0 305 599
- EP-A- 0 420 675
- EP-A- 0 523 325
- WO-A-93/15272
- GB-A- 1 339 045
- US-A- 4 145 480
- RESEARCH DISCLOSURE Bd. 317, Nr. 3175 , September 1990 Seiten 742 - 746 XP141468 'Process for the Rescreening of Halftone Images'

## Beschreibung

Die vorliegende Erfindung betrifft ein Verfahren zur Herstellung von Farbprüfbildern für die graphische Industrie und eine hierfür besonders gut geeignete zusammengesetzte Schicht, welche als Bestandteil des hergestellten Prüfbildes den optischen Punktzuwachs des Verfahrens steuert, sowie Materialien für Prüfverfahren für die graphische Industrie, welche die zusammengesetzte Schicht oder Teilschichten davon enthalten.

In der Reproduktionstechnik werden gerasterte Farbauszüge als Kopiervorlagen für die Herstellung von Offset- oder Hochdruckplatten verwendet. Bevor die Belichtung der Druckplatten erfolgt, werden die Farbauszüge mit Hilfe von Farbprüfverfahren daraufhin überprüft, ob das spätere Druckergebnis eine tonwertrichtige Reproduktion der Vorlage darstellt.

In solchen Farbprüfverfahren finden strahlungsempfindliche Aufzeichnungsmaterialien Verwendung, bei denen zur Bilderzeugung Unterschiede in der Klebrigkeit der belichteten und unbelichteten Bereiche der strahlungsempfindlichen Schicht ausgenutzt werden. So ist z.B. aus den deutschen Patentschriften DE-C 12 10 321, DE-C 19 04 058, DE-C 19 04 059 und DE-C 20 04 214 sowie in US 43 56 253 und EP-A 02 43 933 ein Reproduktionsverfahren bekannt, bei dem ein klebriges photopolymerisierbares Aufzeichnungsmaterial, bestehend aus einem Schichtträger und einer photopolymerisierbaren Schicht, die mindestens ein additionspolymerisierbares Monomeres und einen Photopolymerisationsinitiator enthält, durch bildmäßige Belichtung gehärtet wird, wobei die belichteten Bildteile ihre Klebrigkeit verlieren.

Das latente Bild wird dann durch Aufbringen geeigneter Tonermaterialien sichtbar gemacht, die nur an den unbelichteten, klebrigen Stellen haften, während sie von den belichteten, nicht klebenden Bildteilen nach dem Aufbringen wieder entfernt werden können. Nach diesem Verfahren erhält man positive, gegebenenfalls gefärbte Bilder der Vorlage, die im Aussehen Bildern gleichen, die unter Verwendung von Druckfarben hergestellt wurden.

Negative Bilder der Vorlage erhält man, wenn man die z.B. in den deutschen Patentschriften DE-C 27 58 209, DE-C 30 23 247 und DE-C 34 29 615 beschriebenen lichtempfindlichen Materialien verwendet. Diese Aufzeichnungsmaterialien enthalten als lichtempfindliche Komponente entweder eine Dihydropyridinverbindung oder ein System aus einer Dihydropyridinverbindung und einer Hexarylbisimidazolverbindung.

Das Aufbringen der überwiegend aus feinteiligen Pulvern bestehenden Tonermaterialien kann durch Bestäuben der bildmäßig belichteten Oberfläche mit dem Toner erfolgen, wie sie z.B. in DE-C 29 46 896 und US 39 09 282 beschrieben sind. Nach einer anderen Ausführungsform kann sich der Toner auch lose gebunden auf einem gesonderten Träger befinden und durch Inkontaktbringen dieses Trägers mit der bildmäßig belichteten Schicht übertragen werden. Solche pigmentierten Trägerschichten werden in DE-C 36 25 014 und DE-C 39 41 493 beschrieben.

Die strahlungsempfindlichen Aufzeichnungsmaterialien bestehen üblicherweise aus einem Schichtträger, einer strahlungsempfindlichen Schicht und einer Deckfolie. Diese Deckfolie wird abgezogen und das Material auf ein Bildträger auflaminiert bevor die bildmäßige Belichtung erfolgt. Der Schichtträger kann je nach Material vor oder nach der Belichtung abgezogen werden.

Der Druckprozess verursacht einen mechanischen Punktzuwachs. Dieser Punktzuwachs muß bei einem Farbprüfverfahren selbstverständlich berücksichtigt werden, damit eine tonwertrichtige Reproduktion des späteren Druckergebnisses gewährleistet ist.

Bei dem, in den deutschen Patentschriften DE-C 12 10 321, DE-C 19 04 058, DE-C 27 58 209, DE-C 30 23 247, DE-C 34 29 615, DE-C 19 04 059 und DE-C 20 04 214 sowie in US 43 56 253 und EP-A 02 43 933 beschriebenen Verfahren erhält man einen optischen Punktzuwachs, verursacht im wesentlichen durch die Schichtdicke der photopolymerisierbaren Schichten, der den mechanischen Punktzuwachs in den herkömmlichen Druckprozessen entspricht.

Durch die Weiterentwicklung der modernen Flachdruckverfahren reduziert sich der mechanische Punktzuwachs jedoch, wodurch die oben beschriebenen Farbprüfverfahren nur noch begrenzt in der Lage sind, eine tonwertrichtige Reproduktion des späteren Druckergebnisses moderner Flachdruckverfahren herzustellen.

Für den modernen Flachdruck wird daher von der graphischen Industrie Farbprüfverfahren mit besonders niedrigem optischen Punktzuwachs gefordert.

Eine Reduktion des optischen Punktzuwachses wird in EP-A 03 39 860 durch die Reduktion der Schichtdicke einer zur strahlungsempfindlichen Schicht benachbarten transparenten Hilfsschicht erreicht. Eine andere Möglichkeit der Reduktion des optischen Punktzuwachses in Farbprüfverfahren besteht in der Verwendung von Titandioxid in einer ersten, auf einen Bildträger aufzulaminierenden Schicht, wie es in EP-A 04 20 675 beschrieben ist. Dabei kann die Titandioxid enthaltende Schicht entweder alleine als oberste Schicht auf dem Bildträger oder zusammen mit der ersten strahlungsempfindlichen Schicht auf die bildseitigen Oberfläche des Bildträgers aufgebracht werden.

Farbprüfverfahren, welche Bildträger mit geringem optischen Punktzuwachs verwenden, sind in EP-B 01 86 902 und EP-A 03 05 599 beschrieben. Dabei wird in EP-A 03 05 599 eine Schicht bestehend aus Titandioxid und einem hydrophilen kolloidalem Bindemittel auf einem mit einem Polyolefin beschichteten Basispapier verwendet.

Ebenso beschreibt die ältere EP 0 639 796 ein Bildempfangsmaterial, das auf einem Schichtträger eine ein weißes Pigment enthaltende Pigmentschicht trägt. Aus der PCT Anmeldung WO 93/15272 sind zudem Bildträger mit einer Beschichtung aus einem Bindemittel, Titandioxid und speziellen, lichtstreuenden core/sheat Polymeren bekannt, die eine verbesserte Hintergrundweiße zeigen. Die Research Disclosure Nr.317, Sep. 1990, Abstr. Nr. 31757, beschreibt ein Verfahren zur Verstärkung des Punktzuwachses unter Verwendung von Bildträgern mit Beschichtungen aus einem Bindemittel, Titandioxid und weiteren mattierende Polymeren.

Ein Träger für photographische Emulsionen mit zwei Beschichtungsschichten auf der bildseitigen Oberfläche, wobei ein anorganisches Weißpigment im wesentlichen nur in der äußeren Beschichtungsschicht enthalten ist, ist in GB 13 39 045 beschrieben.

Alle diese Entwicklungen sind jedoch bezüglich des geforderten niedrigen Punktzuwachses im Zusammenhang mit den oben beschriebenen Farbprüfverfahren unzulänglich.

Aufgabe der vorliegenden Erfindung ist es daher, mittels Farbprüfverfahren hergestellte Bilder und Mehrfarbenbilder sowie Mittel und Verfahren zu deren Herstellung vorzuschlagen, welche einen niedrigen optischen Punktzuwachs aufweisen. Dabei sollen aber keine Änderungen an der strahlungsempfindlichen Schicht in dem strahlungsempfindlichen Aufzeichnungsmaterial vorgenommen werden, um dessen Verwendbarkeit auch im Farbprüfverfahren mit einem normalem optischen Punktzuwachs eines 50%-Punktes im Bereich zwischen 19% und 25% zu erhalten.

Diese Aufgabe wird gelöst durch Bildträger zur Herstellung von Farbprüfbilder enthaltend ein Substrat, eine mit der bildseitigen Oberfläche des Substrats fest verbundene Schicht A und auf dieser eine zweite Schicht B, welche mindestens ein lichtreflektierendes Weißpigment und mindestens ein Bindemittel enthält, dadurch gekennzeichnet, daß die Schicht B zusätzlich mindestens ein lichtabsorbierendes Pigment enthält und der Anteil des lichtabsorbierenden Pigments in der Schicht B zwischen 0,0001 und 0,1 Gew.% der Schicht B liegt oder die optische Dichte an ungefärbten Stellen der Bilder und Mehrfarbenbildern einen Wert, gemessen mit einem GRETAG D186 Densitometer (Filter für schwarz), von 0,2 nicht überschreitet, und durch Farbprüfbilder und Verfahren, die solche Bildträger verwenden, bzw. durch Aufzeichnungsmaterialien mit einer Schicht B gemäß Anspruch 1.

Geeignete Polyolefine für die Polyolefin enthaltende Schicht A der erfindungsgemäßen Bilder und Mehrfarbenbilder (nachfolgend als Schicht A bezeichnet) sind beispielsweise hochdichtes oder niedrigdichtes Polyethylen, Polypropylen, deren Mischungen und Copolymere, die im wesentlichen unter Verwendung von Ethylen oder Propylen hergestellt wurden.

In einer bevorzugten Ausführung enthält die Schicht A ein lichtreflektierendes Weißpigment, wodurch der optische Punktzuwachs weiter reduziert wird. Dadurch ist der entsprechende Bildträger besonders gut für die Herstellung von Bildern und Mehrfarbenbildern mittels Farbprüfverfahren für hochwertige Drucke geeignet.

Die Menge des lichtreflektierenden Weißpigments in der Schicht A beträgt maximal 20 Gew.% bezogen auf die Gesamtmasse der Schicht A.

Die Schichtdicke der Schicht A beträgt maximal 100 µm. Bevorzugt ist jedoch eine Schichtdicke von weniger als 60 µm, wobei der Bereich zwischen 5 µm und 40 µm besonders bevorzugt ist.

Geeignete lichtreflektierende Weißpigmente für Schicht A und der, mindestens ein lichtabsorbierendes Pigment, mindestens ein lichtreflektierendes Weißpigment sowie mindestens ein Bindemittel enthaltende Schicht B (nachfolgend als Schicht B bezeichnet) sind beispielsweise Titandioxid der Anatas - und der Rutil-Modifikation, Bariumsulfat, mit Titandioxid beschichteter Glimmer oder deren Mischungen. Besonders gut geeignet ist Titandioxid der Anatas- oder der Rutil-Modifikation.

Das Flächengewicht der Schicht B beträgt 5 g/m² bis 25 g/m². Bevorzugt wird jedoch der Bereich von 10 g/m² bis 20 g/m² verwendet. Am besten geeignet ist ein Flächengewicht von 13 g/m² bis 17 g/m².

In der Schicht B ist das lichtreflektierende Weißpigment mit einen gewichtsmäßigen Anteil zwischen 50% und 90% bezogen auf die Schicht B enthalten.

Als erfindungswesentliche Komponente enthält die Schicht B ein lichtabsorbierendes Pigment, wobei dessen Anteil in der Schicht B zwischen 0,0001 und 0,1 Gew.-% der Schicht B liegt oder die optische Dichte an ungefärbten Stellen der Bilder und Mehrfarbenbildern einen Wert, gemessen mit einem GRETAG D186 Densitometer (Filter für schwarz), von 0,2 nicht überschreitet.

Geeignete lichtabsorbierende Pigmente für die Schicht B sind beispielsweise Schwarzpigmente wie Ruß, synthetisches Eisenoxidschwarz, Graphit und Elfenbeintiefschwarz. Besonders geeignet ist hiervon Ruß.

Geeignete Bindemittel für die Schicht B sind beispielsweise: Ethylen/Vinylacetat Copolymere, Polyester sowie Polymerisate oder Copolymerisate aus Vinylchlorid, Acrylnitril, Acrylate, Vinylacetat, Styrol, und Butadien.

Die Schicht B kann während der Herstellung des Bildträgers nach dem Auftrag der Schicht A als weitere Schicht auf der bildtragenden Seite des Bildträgers aufgetragen werden. Dabei befindet sich die Schicht A näher am Substrat des Bildträgers als die Schicht B.

Die Schicht B kann auch nach der Herstellung des Bildträgers und vor der Auftragung der strahlungsempfindlichen Schicht auf die Schicht A enthaltende Seite des Bildträger aufgetragen werden.

Alternativ kann die Teilschicht B auch in Verbindung mit der strahlungsempfindlichen Schicht als zusätzliche Schicht im strahlungsempfindlichen Aufzeichnungsmaterial nach Entfernen der Deckfolie auf den Bildträger aufgetragen werden. Das dabei zu verwendende strahlungsempfindliche Aufzeichnungsmaterial enthält die Teilschicht B zwischen der Deckfolie und der strahlungsempfindlichen Schicht.

In diesem Fall wird im entsprechenden Farbprüfverfahren ein Bildträger verwendet, welcher nur die Teilschicht A auf der bildtragenden Seite des Bildträgers und gegebenenfalls weitere Schichten auf der Oberfläche der bildtragenden Seite enthält.

Die Schicht B kann in Form einer wässrigen Dispersion auf die entsprechende Unterlage aufgetragen und anschließend getrocknet werden.

Weiterhin kann sich in den erfindungsgemäßen ein- und mehrfarbigen Farbprüfbildern eine Schicht C (nachfolgend als Schicht C benannt) zwischen der Schicht B und der Schicht B am nächsten liegenden strahlungsempfindlichen Schicht befinden.

Diese Schicht C enthält als Bindemittel mindestens ein geeignetes Polymerisat und/oder Copolymerisat. Diese Polymerisate und/oder Copolymerisate können beispielsweise aus Acrylaten, Methacrylaten, Vinylestern, Butadien, Isopren, Ethylen, Propylen, Vinylidenchlorid, Vinylalkylether sowie anderen ethylenisch ungesättigten Verbindungen bestehen. Desweiteren kann die Schicht C gegebenenfalls Weichmacher sowie Netzmittel enthalten.

Besonders geeignet für diese Schicht C sind Polymere und/oder Copolymere, die mindestens zu 80 Gew.% aus ethylenisch ungesättigten Verbindungen wie Butadien, Ethylen, Propylen, Vinylidenchlorid und/oder Isopren bestehen.

Diese Schicht C reduziert das Entstehen von Farbdichteschwankungen bei der Herstellung der ein- und mehrfarbigen Farbprüfbilder. Diese Eigenschaft der Schicht C ist bei Verwendung von strahlungsempfindlichen Schichten mit einer Schichtdicke von weniger als 6 µm zur Herstellung von ein- und mehrfarbigen Farbprüfbildern von besonderer Bedeutung.

Geeignete Schichtdicken der Schicht C liegen im Bereich von 0,5 µm bis 10 µm. In einer besonders bevorzugten Ausführung liegt die Schichtdicke der Schicht C zwischen 1 µm und 5 µm.

Weitere Funktionen der Schicht C können beispielsweise die Vermittlung der Haftung zwischen einem Bildträger und der ersten aufzulaminierenden Schicht sowie eine Diffusionssperre für organische Moleküle wie beispielsweise ethylenisch ungesättigte Verbindungen in der strahlungsempfindlichen Schicht des strahlungsempfindlichen Aufzeichnungsmaterials sein.

Diese Schicht C kann beispielsweise während oder nach der Herstellung eines die Schichten A und B enthaltenden Bildträgers auf die Schicht B aufgetragen werden. Dies kann in Form einer wäßrigen Suspension der entsprechenden polymeren Bestandteilen, welche neben den polymeren Bestandteilen noch weitere Stoffe wie beispielsweise Netzmittel oder Weichmacher enthalten kann, geschehen, welche als oberste Schicht auf den Bildträger aufgetragen und anschließend getrocknet wird.

Zur Herstellung der Schicht C können entsprechende handelsübliche Polymersuspensionen Verwendung finden wie beispielsweise DIOFAN 195D von der Fa. BASF AG.

Diese Schicht C kann auch als oder neben haftvermittelnden oder klebrigen Schichten oder thermoplastische Haftschichten in strahlungsempfindlichen Materialien von Farbprüfverfahren enthalten sein. Solche Materialien sind beispielsweise in DE-A 41 25 723, EP-A 04 20 675, EP-A 03 39 860 und EP-A 05 14 186 beschrieben.

Wenn ein solches strahlungsempfindliches Material die Schicht B enthält, befindet sich die Schicht C zwischen Schicht B und der strahlungsempfindlichen Schicht.

Als tonbare strahlungsempfindliche Gemische im Sinne dieser Erfindung können sowohl positiv tonbare, photohärtbare Systeme, wie sie z.B. in DE-C 12 10 321, DE-C 19 04 058 oder DE-C 20 04 214 genannt sind, als auch negativ tonbare, bei Bestrahlung klebrig werdende Systeme, wie sie z.B. in DE-C 27 58 209, DE-C 30 23 247 und DE-C 34 29 615 beschrieben sind, verwendet werden. Die genannten negativ tonbaren Aufzeichnungsmaterialien enthalten entweder eine Dihydropyridinverbindung oder ein lichtempfindliches System aus einer Hexarylbisimidazolverbindung und einem Dihydropyridin.

Bevorzugt werden aber positiv tonbare photopolymersierbare Aufzeichnungsmaterialien für die vorliegende Erfindung verwendet. Insbesondere die in EP-A 02 43 932 und EP-A 02 43 933 beschriebenen Materialien werden bevorzugt eingesetzt. Diese Materialien enthalten ein polymeres Bindemittel, mindestens eine photopolymersierbare Verbindung, einen Photoinitiator und ggf. weitere Hilfsstoffe wie Weichmacher, Sensibilisatoren, Füllstoffe, Antioxidantien und optische Aufheller. Bevorzugte Bindemittel sind die in der EP-A 02 43 933 genannten Polymere mit einer Glastemperatur < 70° C, bzw. < 80° C bei Polymergemischen, und mit salzbildenden Gruppen, welche durch Metallionen ionisch vernetzt sind. Besonders bewährt haben sich thermoplastische Bindemittel auf Acrylat und/oder Methacrylatbasis, welche die salzbildenden Gruppen z.B. in Form von Acrylsäure oder Methacrylsäure enthalten. Die Metallionen sind bevorzugt Magnesium, Kalzium, Strontium, Barium, Aluminium, Zinn, Zink, Cadmium, Titan, Zirkon und Mangan, die als Salze, bevorzugt als Chelate zugesetzt werden.

Die tonbaren strahlungsempfindlichen Gemische können nach bekannten Methoden auf geeignete vorzugsweise transparente, Schichtträger aufgetragen und anschließend getrocknet werden. Geeignete Schichtträger sind beispielsweise Kunststoffolien aus Polyethylen, Polypropylen, Polyamid und Polyester. Bevorzugt wird eine Polyethylenterephthalatfolie verwendet.

Bei der Verwendung von nichttransparenten Schichtträgern, werden diese vor der bildmäßigen Belichtung abgezogen.

Die Seite der Aufzeichnungsschicht, die dem Schichtträger abgewandt ist, wird mit einer flexiblen Deckschicht, beispielsweise einer dünnen Folie aus Polystyrol, Polyethylen, Polypropylen oder Polyethylenterephthalat versehen. Bevorzugt wird eine Polypropylenfolie verwendet.

Die Schichtdicke der Aufzeichnungsschicht liegt bevorzugt zwischen 2 µm und 0,1 mm.

Die strahlungsempfindlichen Materialien besitzen ihre maximale Empfindlichkeit im UV-Bereich, bevorzugt im Wellenlängenbereich zwischen 250 und 450 nm.

Zur Belichtung sind daher alle Strahlungsquellen geeignet, die eine wirksame Menge dieser Strahlung liefern; beispielsweise Xenonlampen, Quecksilberdampflampen und Kohlebogenlampen, Laser Fluoreszenzlampen mit UV-Strahlung emittierenden Leuchtstoffen und Elektronenblitzgeräten.

Das Tonen der bildmäßig belichteten Aufzeichnungsschicht kann sowohl durch Bestäuben mit überwiegend aus feinteiligen Pulvern bestehenden Tonermaterialien erfolgen, wie sie z.B. aus DE-C 29 46 896 und US 39 09 282 bekannt sind, wie auch mit pigmentierten Tonungsfolien, die das Tonermaterial lose gebunden auf einem gesonderten Träger enthalten. Solche Tonungsfolien werden z.B. in DE-C 39 41 493 und DE-C 36 25 014 und DE-C 37 06 528 beschrieben.

Das Hauptanwendungsgebiet der Erfindung liegt in der Herstellung von Ein- und Mehrfarbenbildern und in der Verwendung für Farbprüfverfahren. Beispiele solcher Farbprüfverfahren sind in EP-A 03 52 055, DE-A 42 09 873, EP-A 04 03 128, EP-A 04 87 797, DE-A 41 25 723, EP-A 05 14 186, DE-A 37 20 724, US 36 71 236, DE-A 41 10 057 sowie EP-A 03 57 325 beschrieben.

Als Substrat eignen sich Träger wie Papier, Pappe, Metalle, Folien oder Platten aus Polymeren wie z.B. Polyethylen, Polyester, Polyvinylchlorid, Polyamid, die auf der bildtragenden Seite mindestens die Schicht A enthalten, und, falls in dem entsprechenden Farbprüfverfahren ein strahlungsempfindliches Aufzeichnungsmaterial, welches die Schicht B nicht enthält, verwendet wird, zusätzlich auf der Schicht A liegend die Schicht B sowie gegebenenfalls eine haftvermittelnde Schicht enthalten. Besonders gut geeignet ist Papier.

Der Bildträger kann ansonsten unverändert sein oder weitere Beschichtungen aufweisen. Die Schichten A, B und C sowie gegebenenfalls weitere Beschichtungen des Bildträgers können neben den erfindungsgemäßen Bestandteilen und anderen üblichen Bestandteilen weitere Substanzen wie Pigmente, Füller, optische Aufheller, UV-Absorber und Antistatikmittel enthalten.

Die Durchführung eines Farbprüfverfahrens gemäß der vorliegenden Erfindung kann beispielsweise die folgenden Verfahrensschritte umfassen.

Nach dem Entfernen der Deckfolie wird ein positiv tonbares photopolymerisierbares Aufzeichnungsmaterial auf ein Bildträger, welcher als äußerste Schichten der bildzugewandten Seite die Schicht A, die Schicht B und gegebenenfalls eine haftvermittelnde Schicht enthält, auflaminiert, wobei die strahlungsempfindliche Schicht, sowohl im polymerisierten, wie auch im unpolymerisierten Zustand zur Oberfläche des Bildträgers eine größere Haftung aufweist als zum Schichtträger.

Dann wird das Material durch den transparenten Schichtträger hindurch unter Verwendung eines gerasterten Farbauszugs-Positivs einer ersten Farbe als Vorlage mit aktinischer Strahlung zur Ausbildung nicht klebriger Bereiche belichtet. Sodann wird der Schichtträger durch Delaminieren entfernt. Das auf dem Bildträger erzeugte latente Bild wird durch Aufbringen eines Toners, der ausschließlich auf den unbelichteten Schichtteilen haftet, sichtbar gemacht. Der Toner wird von den gehärteten Bildteilen entfernt, die dann völlig frei von Toner sind. Man erhält auf diese Weise ein der Vorlage entsprechendes einfarbiges Bild.

Ein zweites Laminat des photopolymerisierbaren Materials wird nach der Entfernung der Deckfolie auf das Bild auflaminiert und unter gleichen Bedingungen durch ein Farbauszugs-Positiv einer zweiten Farbe als Vorlage belichtet und getont. Dieser Vorgang wird dann für einen Farbauszug einer dritten Farbe und falls erwünscht, für einen Schwarzauszug wiederholt.

Man erhält auf diese Weise ein den Vorlagen entsprechendes vierfarbiges Bild.

Anschließend kann auf das Ein- oder Mehrfarbenbild eine Schutzschicht aufgebracht werden, die z.B. aus einem weiteren Laminat des photohärtbaren strahlungsempfindlichen Materials besteht, von dem nach flächenmäßiger Belichtung der Schichtträger entfernt wird.

Bei der Verwendung eines negativ tonbaren, bei Bestrahlung klebrig werdenden Aufzeichnungsmaterials ist die Durchführung eines Farbprüfverfahrens ganz analog, nur daß anstelle von Farbauszugs-Positiven Farbauszugs-Negative verwendet werden.

In einer alternativen Ausführungsform dazu kann auch von einem positiv tonbaren photopolymerisierbarem Aufzeichnungsmaterial, welches zwischen der Deckfolie und der strahlungsempfindlichen Schicht die Schicht B enthält, die Deckfolie abgezogen und auf einen Bildträger, welcher die Schicht A auf der bildzugewandten Seite trägt und gegebenenfalls mit einer haftvermittelnde Schicht beschichtet ist, auflaminiert werden, wobei die strahlungsempfindliche Schicht, sowohl im polymerisierten, wie auch im unpolymerisierten Zustand zur Oberfläche des Bildträgers eine größere Haftung aufweist als zum Schichtträger. Die weiteren Verfahrensschritte sind die gleichen wie in dem vorhergehend beschriebenen Verfahren.

Bei geeigneter Wahl der Bindemittel und gegebenenfalls Weichmacher für die Schicht B kann diese auch die Funktion einer haftvermittelnden Schicht ausüben.

### Beispiel 1 :

Es wurden zwei harzbeschichtete Bildträger A und B hergestellt (Vergleichsbeispiele). A besteht aus einem Substrat aus Papier, das auf seiner bildtragenden Vorderseite eine zusammengesetzte Beschichtung mit einer ersten Schicht bestehend aus Polyethylen und einer über dieser liegenden, mit dieser fest verbundenen weiteren Schicht, bestehend zu 20 % aus einer Bindemittelmischung aus 7,2 Teilen Polyacrylester/Polystyrol Copolymer, 1 Teil Polyacrylester/Polyvinylacetat/Acrylsäure Copolymer sowie 0,17 Teilen einer Polycarbonsäure und zu 80 % aus Titandioxid-Pulver trägt. Das Flächengewicht dieser Schicht beträgt 15 g/m². Der harzbeschichtete Bildträger B ist wie A aufgebaut, enthält aber zusätzlich in der ersten Beschichtungsschicht (Polyethylenschicht) 10 Gew. % Titandioxid-Pulver. Die beiden harzbeschichteten Bildträger A und B wurden jeweils mit einer 4 µm dicken positiv arbeitenden, tonbaren photohärtbaren Mischung, wie in EP-B 02 43 933 beschrieben, beschichtet und in einem Belichtungsgerät durch eine gerasterte Vorlage mit aktinischem Licht belichtet. Die Vorlage enthält Testfelder mit unterschiedlicher Flächendeckung zur Bestimmung des Punktzuwachses. Die Belichtung erzeugt bildmäßig verteilte klebrige und nichtklebrige Stellen. Die klebrigen Stellen wurden danach mittels einer Cyanfarbfolie eingefärbt. Auf der Cyanbildschicht wurden anschließend nacheinander vier mal eine weitere tonbare photohärtbare Mischung auflaminiert und jeweils durch Belichtung mit aktinischem Licht gehärtet. Der Punktzuwachs der Rasterpunkte des Cyanbildes gegenüber der Vorlage wurde mit einem Densitometer (GRETAG D186) bestimmt. Es wurden jeweils 6 Meßfelder mit einer Flächendeckung von 27 % und 50 % (in der Belichtungsvorlage) vermessen und der Mittelwert berechnet. Der Punktzuwachs ist die Differenz zwischen der Flächendeckung in der Vorlage und dem entsprechenden Meßwert.

Es wurden zwei weitere harzbeschichtete Bildträger C wie A und D wie B hergestellt, wobei jedoch C und D zusätzlich 0,002 Gew.% eines Schwarzpigments (Printex 300, DEGUSSA) in der zweiten Beschichtungsschicht enthielten. Die optische Dichte der beiden Bildträger C und D lag, gemessen mit einem Densitometer (GRETAG D186) (Filter für schwarz) bei 0,02. Wiederum wurde jeweils ein Cyanbild auf dem so hergestellten Bildträger erzeugt und der Punktzuwachs bestimmt.

**Tabelle 1**

| Bildträger | Punktzuwachs (50 %-Punkt) | Punktzuwachs (27 %-Punkt) | Ruß in 2. Schicht | TiO₂ in 1. Schicht |
|---|---|---|---|---|
| A (Vergleich) | 21,5 % | 21,3 % | nein | nein |
| B (Vergleich) | 21 % | 20 % | nein | ja |
| C (Erfindung) | 18 % | 16 % | ja | nein |
| D (Erfindung) | 17% | 15% | ja | ja |

Durch das zusätzlich in der ersten Beschichtungsschicht (Polyethylenschicht) zugesetzte Titandioxid-Pulver in Material B ergibt sich, verglichen mit Material A eine Reduktion des optischen Punktzuwachses eines 50%-Punktes von 0,5 % und eines 27%-Punktes von 1,3 %.

Der Zusatz von Schwarzpigment in der zweiten Beschichtungsschicht bewirkt die erfindungsgemäße Reduktion des Punktzuwachses. Eine weitere Reduktion des Punktzuwachses des 50%-Punktes auf 17% ohne weiteren Zusatz von Schwarzpigment wird durch die Kombination der Titandioxid enthaltenden Polyethylenschicht mit der Schwarzpigment und Weißpigment enthaltenden zweiten Beschichtungsschicht, wie mit Bildträger D gezeigt, erhalten.

### Beispiel 2 :

Eine Mischung aus 50 g TiO₂-Pulver, 13 g einer Polyacrylester/ Polystyrol Copolymer-Dispersion (Feststoffgehalt 50%), 3 g einer Polyacrylester/Polyvinylacetat/ Acrylsäure Copolymer-Dispersion (Feststoffgehalt 40%) und 0,15 g eines Netzmittels (Polycarbonsäure) wurden in 33 g Wasser dispergiert. Diese Dispersion wurde mit verschiedenen Mengen eines schwarzen Pigments (Printex 300, DEGUSSA) versetzt und mit einem Spiralrakel auf die bildtragenden Seite eines mit Polyethylen beschichteten Substrats aus Papier so aufgebracht, daß das Trockengewicht der Schicht 15 g / m² betrug. Wie in Beispiel 1 beschrieben wurde ein Cyan-Bild auf dem so hergestellten Bildträger erzeugt und der Punktzuwachs bestimmt.

**Tabelle 2**

| Schwarzpigment (Gew % in Schicht) | Punktzuwachs (50 %-Punkt) | Punktzuwachs (27 %-Punkt) | Optische Dichte |
|---|---|---|---|
| 0,00 % | 23 % | 22 % | 0,00 |
| 0,01 % | 18 % | 16 % | 0,05 |
| 0,05 % | 16 % | 15 % | 0,18 |
| 0,10 % | 16 % | 13 % | 0,21 |

Durch die Verwendung des Schwarzpigmentes in einer Menge von 0,05 Gew.%, bezogen auf die getrocknete, das Schwarzpigment enthaltende Schicht wird der geforderte niedrige optische Punktzuwachs der 50%-Punkte erhalten. Das entsprechende Material kann aber nicht mehr für Farbprüfverfahren für hochwertige Drucke verwendet werden, da es schon ab einen Schwarzpigmentzusatz von 0,01% zu grau wirkt, um damit eine tonwertrichtige Reproduktion des späteren Druckergebnisses zu erreichen.

### Beispiel 3:

Auf die positiv arbeitende, tonbare photohärtbare Mischung nach EP-B 02 43 933 wurde eine, das lichtabsorbierende Pigment und das lichtreflektierende Weißpigment enthaltende Schicht wie in Beispiel 1 auf Bildträger C und D aufgebracht. Danach wurde dieses so modifizierte strahlungsempfindliche Material auf den Bildträger B aus Beispiel 1 auflaminiert. Wie in Beispiel 1 beschrieben wurde ein Cyanbild auf dem so hergestellten Bildträger erzeugt und der Punktzuwachs bestimmt. Das Cyanbild und der optische Punktzuwachs des so hergestellten Cyanbildes unterscheidet sich nicht von dem Cyanbild beziehungsweise dessen optischen Punktzuwachses, welches in Beispiel 1 unter Verwendung des Bildträgers D hergestellt wurde.

### Beispiel 4

Zur Herstellung eines mehrfarbigen Farbprüfbildes wurde ein Aufzeichnungsmaterial und pigmentierte Übertragungsschichten der Farben Cyan, Magenta, Gelb und Schwarz nach der Angabe des Beispiels 12 der DE-C 39 31 493 verwendet. Eine erste 4 µm dicke positiv arbeitenden, tonbaren photohärtbaren Mischung wird nach Entfernung der Deckfolie auf ein analog dem Bildträger D aus Beispiel 1 aufgebautem Bildträger auflaminiert und durch einen gerasterten positiven Cyan-Farbauszug in einem Vakuumkopierrahmen mit einer Metallhalogenidlampe (3 000 Watt) unter Verwendung eines ultraviolett-durchlässigen Filters 42 s im Abstand von 95 cm belichtet. Nach Entfernung des Schichtträgers wird die Cyan-Übertragungsschicht auf die bildmäßig belichtete Schicht auflaminiert und sofort wieder abgezogen. Die Übertragungsschicht bleibt nur auf den unbelichteten, klebrigen Stellen haften, und man erhält ein positives Cyanbild der Vorlage.

Eine zweite 4 µm dicke positiv arbeitenden, tonbaren photohärtbaren Mischung wird nach Entfernung der Deckfolie auf das Cyanbild auflaminiert und wie oben durch den entsprechenden gerasterten Magenta-Farbauszug belichtet. Nach Entfernung des Schichtträgers wird die Magenta-Übertragungsschicht auf die bildmäßig belichtete Schicht auflaminiert und wieder abgezogen. Die Übertragungsschicht bleibt nur an den unbelichteten klebrigen Stellen haften, und man erhält ein positives Magentabild. Für die Farben Gelb und Schwarz werden die Arbeitsschritte entsprechend wiederholt und anschließend in üblicher Weise eine Schutzschicht aufgebracht. Man erhält einen vierfarbiges Farbprüfbild von ausgezeichneter Brillanz und Schärfe mit einer Auflösung von 1% - 99% im 60-Linien/cm-Raster, der eine naturgetreu Wiedergabe des Originals darstellt. Die Haftung der Aufzeichnungsschichten auf dem harzbeschichteten Bildträger war ausgezeichnet. Das entstandene Mehrfarbenbild wies den geforderten niedrigen Punktzuwachs auf.

### Beispiel 5

Es wurde ein Bildträger E hergestellt, indem auf die bildseitige Oberfläche eines Bildträgers D nach Beispiel 1 eine wäßrige Dispersion eines Copolymeren aus Vinylidenchlorid (90 gew.%) und Acrylsäuremethylester (10 gew.%) mit Hilfe eines Spiralrakels aufgetragen und anschließend bei 60° getrocknet wurde, so daß eine Schicht C mit einer Schichtdicke von 3 µm entstand. Die verwendete wäßrige Dispersion enthielt einen Feststoffanteil von 25 gew.% und einen Netzmittelanteil von weniger als 5 gew.%. Der Naßauftrag betrug 12 g/m².

Die Bildträger D und E wurden jeweils mit einer 4 µm dicken positiv arbeitenden tonbaren photohärtbaren Mischung beschichtet und anschließend 15 Stunden bei 25° unter Lichtausschluß aufbewahrt. Danach wurden die Proben jeweils mit einer CYAN Farbfolie getont und die jeweils erzielte Farbdichte mit einem Densitometer (GRETAG D186) gemessen. Das Meßfeld betrug dabei etwa 25 mm².

Ein weiterer Bildträger E wurde wie zuvor beschrieben beschichtet und direkt im Anschluß an die Beschichtung mit einer CYAN Farbfolie getont und die Farbdichte entsprechend bestimmt. Die gemessenen Farbdichten sind in Tabelle 3 aufgeführt.

**Tabelle 3**

| Bildträger | Aufbewährung (Stunden) | Farbdichte |
|---|---|---|
| E | 15 | 1,18 |
| D | 15 | 1,09 |
| E | 0 | 1,19 |

Das Beispiel zeigt, daß die Farbdichte auf dem Bildträger E die erwartete Farbdichte von 1,18 aufweist, während dies der Bildträger D nicht leistet.
Die Farbdichte auf Bildträger E bleibt konstant, wenn die Probe zwischen dem Beschichten mit der positiv arbeitenden, tonbaren Photopolymerschicht und dem Tonen 15 Stunden bei 25° unter Lichtausschluß aufbewahrt wird.

## Patentansprüche

1. Bildträger zur Herstellung von Farbprüfbilder enthaltend ein Substrat, eine mit der bildseitigen Oberfläche des Substrats fest verbundene Schicht A und auf dieser eine zweite Schicht B, welche mindestens ein lichtreflektierendes Weißpigment und mindestens ein Bindemittel enthält,
dadurch gekennzeichnet, daß
die Schicht B zusätzlich mindestens ein lichtabsorbierendes Pigment enthält und der Anteil des lichtabsorbierenden Pigments in der Schicht B zwischen 0,0001 und 0,1 Gew.% der Schicht B liegt oder die optische Dichte an ungefärbten Stellen der Bilder und Mehrfarbenbildern einen Wert, gemessen mit einem GRETAG D186 Densitometer (Filter für schwarz), von 0,2 nicht überschreitet.

2. Bildträger nach Anspruch 1, dadurch gekennzeichnet, daß das als Substrat Papier verwendet wird.

3. Bildträger nach einem der Ansprüche 1 oder 2, dadurch gekennzeichnet, daß
daß die Schicht A ein lichtreflektierendes Weißpigment enthält.

4. Bildträger nach einem der Ansprüche 1 bis 3,
dadurch gekennzeichnet, daß
daß das lichtreflektierende Weißpigment in der Schicht A und der Schicht B im wesentlichen Titandioxid ist.

5. Bildträger nach einem der Ansprüche 1 bis 4,
dadurch gekennzeichnet, daß
der gewichtsmäßige Anteil des Weißpigments in der Schicht B zwischen 50 und 90 % bezogen auf die Schicht B beträgt und das Flächengewicht der Schicht B zwischen 5 und 25 g /m² liegt.

6. Bildträger nach einem der Ansprüche 1 bis 5,
dadurch gekennzeichnet, daß
das lichtreflektierende Weißpigment in der Schicht A höchstens 20 Gew.% bezogen auf die Schicht A beträgt.

7. Bildträger nach einem der Ansprüche 1 bis 6,
dadurch gekennzeichnet, daß
das Flächengewicht der Schicht B zwischen 10 und 20 g/m² liegt.

8. Bildträger nach einem der Ansprüche 1 bis 7,
dadurch gekennzeichnet, daß
das lichtabsorbierende Pigment ein Schwarzpigment ist.

9. Bildträger nach einem der Ansprüche 1 bis 8,
dadurch gekennzeichnet, daß
das Flächengewicht der Schicht B zwischen 13 und 17 g/m² beträgt, das lichtabsorbierende Pigment Ruß ist und in der Schicht B mit einem gewichtsmäßigem Anteil zwischen 0,0001 und 0,01 % bezogen auf die Schicht B enthalten ist oder die optische Dichte an ungefärbten Stellen der Bilder und Mehrfarbenbildern einen Wert, gemessen mit einem GRETAG D186 Densitometer (Filter für schwarz), von 0,05 nicht überschreitet.

10. Bildträger nach einem der Ansprüche 1 bis 9,
dadurch gekennzeicnet, daß
der Bildträger auf seiner bildseitigen Oberfläche mindestens eine weitere Schicht C enthält, welche weiter von dem Substrat entfernt ist als die Schicht B und eine Schichtdicke zwischen 0,5 µm und 10 µm aufweist.

11. Bildträger nach einem der Ansprüche 1 bis 10,
dadurch gekennzeichnet, daß
die Schicht C eine Schichtdicke zwischen 1 µm und 5 µm aufweist.

12. Bildträger nach einem der Ansprüche 1 bis 11,
dadurch gekennzeicnet, daß
die Schicht C mindestens ein Polymerisat und/oder Copolymerisat enthält, welches zu mindestens 80 Gew.% aus Vinylidenchlorid, Butadien, Ethylen, Propylen und/oder Isopren besteht.

13. Strahlungsempfindliches Aufzeichnungsmaterial zur Herstellung von Bildern und Mehrfarbenbildern mittels Farbprüfverfahren, enthaltend einen transparenten Schichtträger, eine strahlungsempfindliche Schicht, eine Schicht B gemäß einem der Ansprüche 1, 4, 5 oder 7 bis 9 und eine Schutzschicht, wobei sich die Schicht B zwischen der Schutzschicht und der strahlungsempfindlichen Schicht befindet.

14. Strahlungsempfindliches Aufzeichnungsmaterial nach Anspruch 13, dadurch gekennzeichnet, daß sich zwischen der strahlungsempfindlichen Schicht und der Schicht B mindestens eine weitere Schicht C gemäß einem der Ansprüche 10 bis 12 befindet.

15. Ein- und mehrfarbige Farbprüfbilder enthaltend einen Bildträger gemäß einem der Ansprüche 1 bis 12 und mindestens eine Farbmittel tragende Schicht.

16. Verfahren zur Herstellung von Farbprüfbildern, bei dem
a) auf einen Bildträger gemäß einem der Ansprüche 1 bis 12 eine strahlungsempfindliche Aufzeichnungsschicht auf einem transparenten Schichtträger so aufgebracht wird, daß die strahlungsempfindliche Schicht in Kontakt zu der Schicht B steht,
b) die strahlungsempfindliche Schicht durch den Schichtträger bildmäßig belichtet wird,
c) der Schichtträger abgezogen wird und
d) auf die klebrigen Bereiche der belichteten Schicht ein Tonermaterial aufgebracht wird.

17. Verfahren gemäß Anspruch 16, dadurch gekennzeichnet, daß unter Schritt a) auf einen Bildträger, welcher auf der bildseitigen Oberfläche die Schicht A aber keine Schicht B trägt, ein strahlungsempfindliches Aufzeichnungsmaterial gemäß einem der Ansprüche 13 oder 14 nach Entfernung der Schutzschicht so auf der bildseitigen Oberfläche des Bildträgers aufgebracht wird, daß die Schicht B in Kontakt zur bildseitigen Oberfläche des Bildträgers steht.

18. Verfahren gemäß Anspruch 16, bei dem die Schritte a) bis d) gemäß Anspruch 16 mehrfach wiederholt werden, wobei unter a) die neue strahlungsempfindliche Aufzeichnungsschicht auf die gemäß den vorhergehenden Schritten behandelte strahlungsempfindliche Aufzeichnungsschicht aufgebracht wird.

19. Verfahren gemäß Anspruch 17, bei dem die Schritte a) bis d) gemäß Anspruch 17 mehrfach wiederholt werden, wobei unter a) das neue strahlungsempfindliche Aufzeichnungsmaterial auf die gemäß den vorhergehenden Schritten behandelte strahlungsempfindliche Aufzeichnungsschicht aufgebracht wird.

20. Verfahren gemäß einem der Ansprüche 16 bis 19, dadurch gekennzeichnet, daß
vor dem bildmäßigen Belichten der Schichtträger entfernt wird.

## Claims

1. Image carrier for making color proofs comprising a substrate, a layer A firmly bonded with the image-side surface of the substrate, and on this a second layer B containing at least a light-reflecting white pigment and at least a binder
characterized in that,
layer B additionally contains at least one light-absorbing pigment and the proportion of light-absorbing pigment in layer B is between 0.0001 and 0.1 percent by weight of layer B, or the optical density in the uncolored areas of the images and polychrome images does not exeed a value of 0.2 as measured with a Gretag D186 densitometer (filter for black).

2. Image carrier according to claim 1,
characterized in that,
paper is used as substrate.

3. Image carrier according to claim 1 or 2,
characterized in that,
layer A contains a light-reflecting white pigment.

4. Image carrier according to one of claims 1 to 3,
characterized in that,
the light-reflecting white pigment in layer A and in layer B essentially is titanium dioxide.

5. Image carrier according to one of claims 1 to 4,
characterized in that,
the weight proportion of white pigment in layer B is between 50 and 90 % relative to layer B and the weight per unit area of layer B is between 5 and 25 g/m².

6. Image carrier according to one of claims 1 to 5,
characterized in that,
the light-reflecting white pigment in layer A is at most 20 % by weight relative to layer A.

7. Image carrier according to one of claims 1 to 6,
characterized in that,
the weight per unit area of layer B is between 10 and 20 g/m².

8. Image carrier according to one of claims 1 to 7,
characterized in that,
the light-absorbing pigment is a black pigment.

9. Image carrier according to one of claims 1 to 8,
characterized in that,
the weight per unit area of layer B is between 13 and 17 g/m², the light-absorbing pigment is carbon black and is contained in layer B in a weight proportion between 0.0001 and 0.01 % relative to layer B, or the optical density in the uncolored areas of the images and polychrome images does not exeed a value of 0.05 as measured with a Gretag D186 densitometer (filter for black).

10. Image carrier according to one of claims 1 to 9,
characterized in that,
the image carrier contains at least one further layer C on its image-side surface which is farther away from the substrate than layer B and is between 0.5 µm and 10 µm thick.

11. Image carrier according to one of claims 1 to 10,
characterized in that,
layer C is between 1 µm and 5 µm thick.

12. Image carrier according to one of claims 1 to 11,
characterized in that,
layer C contains at least one polymer and/or copolymer consisting of at least 80 % by weight of vinylidene chloride, butadiene, ethylene, propylene, and/or isoprene.

13. Radiation-sensitive recording material for preparation of images and polychrome images by color proofing processes, comprising a transparent support, a radiation-sensitive layer, a layer B according to one of the claims 1, 4, 5, or 7 to 9 and a cover layer, wherein layer B is between the cover layer and the radiation-sensitive layer.

14. Radiation-sensitive recording material according to claim 13,
characterized in that,
at least one further layer C according to one of the claims 10 to 12 is located between the radiation-sensitive layer and the layer B.

15. Monochrome and polychrome color proofs comprising an image carrier according to one of the claims 1 to 12 and at least one layer bearing a coloring agent.

16. Process for the preparation of color proofs, in which
a) a radiation-sensitive recording layer on a transparent support is applied on an image carrier according to one of the claims 1 to 12 so that the radiation-sensitive layer is in contact with layer B,
b) the radiation-sensitive layer is exposed imagewise through the support,
c) the support is stripped off, and
d) a toner material is applied to the tacky areas of the exposed layer.

17. Process according to claim 16, characterized in that, in step a) after removal of the cover layer a radiation-sensitive recording material according to one of the claims 13 or 14 is applied to the image-side surface of an image carrier which does bear a layer A on the image-side surface but no layer B in such a way that the layer B is in contact with the image-side surface of the image carrier.

18. Process acording to claim 16, in which steps a) to d) according to claim 16 are repeated several times, wherein under a) the new radiation-sensitive recording layer is applied on the radiation-sensitve recording layer treated according to the preceding steps.

19. Process according to claim 17, in which steps a) to d) according to claim 17 are repeated several times , wherein under a) the new radiation-sensitive recording layer is applied on the radiation-sensitve recording layer treated according to the preceding steps.

20. Process according to one of the claims 16 to 19,
characterized in that,
the support is removed before imagewise exposure.

## Revendications

1. Support d'image pour la production d'épreuves en couleurs contenant un substrat, une couche A fixée à la surface côté image du substrat et, sur celle-ci, une seconde couche B, qui contient au moins un pigment blanc photoréfléchissant et au moins un agent liant,
caractérisé en ce que la couche B contient en outre au moins un pigment photo-absorbant et la proportion du pigment photo-absorbant de la couche B se situe entre 0,0001% et 0,1% en poids de la couche B ou la densité optique aux emplacements non colorés des images et des images en plusieurs couleurs ne dépasse pas une valeur de 0,2, mesurée par un densitomètre GRETAG D186 (filtre pour le noir).

2. Support d'image selon la revendication 1, caractérisé en ce qu'on utilise comme substrat du papier.

3. Support d'image selon l'une des revendications 1 ou 2, caractérisé en ce que la couche A contient un pigment blanc photoréfléchissant.

4. Support d'image selon l'une des revendications 1 à 3, caractérisé en ce que le pigment blanc photoréfléchissant de la couche A et de la couche B est en substance du dioxyde de titane.

5. Support d'image selon l'une des revendications 1 à 4, caractérisé en ce que la proportion en poids du pigment blanc de la couche B se situe entre 50% et 90% par rapport à la couche B et en ce que le poids de surface de la couche B se situe entre 5 et 25 g/m².

6. Support d'image selon l'une des revendications 1 à 5, caractérisé en ce que le pigment blanc photoréfléchissant de la couche A est au maximum présent à raison de 20% en poids par rapport à la couche A.

7. Support d'image selon l'une des revendications 1 à 6, caractérisé en ce que le poids de surface de la couche B se situe entre 10 et 20 g/m².

8. Support d'image selon l'une des revendications 1 à 7, caractérisé en ce que le pigment photo-absorbant est un pigment noir.

9. Support d'image selon l'une des revendications 1 à 8, caractérisé en ce que le poids de surface de la couche B se situe entre 13 et 17 g/m², le pigment photo-absorbant est de la suie et est contenu dans la couche B à raison d'une proportion en poids entre 0,0001% et 0,01% par rapport à la couche B ou la densité optique aux emplacements non colorés des images et des images à plusieurs couleurs ne dépasse pas une valeur de 0,05, mesurée par un densitomètre GRETAG D186 (filtre pour le noir).

10. Support d'image selon l'une des revendications 1 à 9, caractérisé en ce que le support d'image contient sur sa surface côté image au moins une autre couche C, qui est plus éloignée du substrat que la couche B et présente une épaisseur de couche entre 0,5 µm et 10 µm.

11. Support d'image selon l'une des revendications 1 à 10, caractérisé en ce que la couche C présente une épaisseur de couche entre 1 µm et 5 µm.

12. Support d'image selon l'une des revendications 1 à 11, caractérisé en ce que la couche C contient au moins un polymère et/ou un copolymère, qui est constitué d'au moins 80% en poids de chlorure de vinylidène, de butadiène, d'éthylène, de propylène et/ou d'isoprène.

13. Matériau d'enregistrement sensible aux rayonnements pour produire des images et des images à plusieurs couleurs au moyen d'un procédé de production d'épreuves en couleurs, contenant un support de couche transparent, une couche sensible aux rayonnements, une couche B selon l'une des revendications 1, 4, 5 ou 7 à 9, et une couche de protection, la couche B se trouvant entre la couche de protection et la couche sensible aux rayonnements.

14. Matériau d'enregistrement sensible aux rayonnements selon la revendication 13, caractérisé en ce qu'au moins une autre couche C selon l'une des revendications 10 à 12 se trouve entre la couche sensible aux rayonnements et la couche B.

15. Image d'épreuve de couleurs monochrome et polychrome contenant un support d'image selon l'une des revendications 1 à 12 et au moins une couche portant un agent colorant.

16. Procédé de production d'images d'épreuve en couleurs, dans lequel :
a) on applique sur un support d'image selon l'une des revendications 1 à 12 une couche d'enregistrement sensible aux rayonnements sur un support de couche transparent de telle sorte que la couche sensible aux rayonnements soit en contact avec la couche B,
b) la couche sensible aux rayonnements est exposée à travers le support de couche pour former une image,
c) le support de couche est retiré, et
d) un toner est appliqué sur les zones collantes de la couche exposée.

17. Procédé selon la revendication 16, caractérisé en ce que l'on applique à l'étape a) sur un support d'image, qui porte la couche A sur la surface côté image, mais aucune couche B, un matériau d'enregistrement sensible aux rayonnements selon l'une des revendications 13 ou 14 après retrait de la couche de protection sur la surface côté image du support d'image de telle sorte que la couche B soit en contact avec la surface côté image du support d'image.

18. Procédé selon la revendication 16, dans lequel les étapes a) à d) selon la revendication 16 sont répétées à plusieurs reprises, la nouvelle couche d'enregistrement sensible aux rayonnements étant appliquée, à l'étape a), sur la couche d'enregistrement sensible aux rayonnements traitée selon les étapes précédentes.

19. Procédé selon la revendication 17, dans lequel les étapes a) à d) selon la revendication 17 sont répétées à plusieurs reprises, le nouveau matériau d'enregistrement sensible aux rayonnements étant appliqué, à l'étape a), sur la couche d'enregistrement sensible aux rayonnements traitée selon les étapes précédentes.

20. Procédé selon l'une des revendications 16 à 19, caractérisé en ce que l'on retire le support de couche avant l'exposition pour former une image.
